# EUROPEAN PATENT APPLICATION

(11) **EP 4 435 460 A1**
(43) Date of publication of application: **25.09.2024**
(21) Application number: 23163045.0
(22) Date of filing: 21.03.2023
(51) Int. Cl.: G01R 33/56, G01R 33/48, G01R 33/561, G06N 3/02

(54) **IMAGE RECONSTRUCTION FROM MAGNETIC RESONANCE IMAGING DATA ACQUIRED USING PARTIAL FOURIER ACQUISITION SCHEME**

(71) Applicant: Siemens Healthineers AG, 91301 Forchheim (DE)
(72) Inventor: Benkert, Thomas, 91077 Neunkirchen am Brand (DE); Gadjimuradov, Fasil, 91054 Erlangen (DE); Nickel, Marcel Dominik, 91074 Herzogenaurach (DE)
(74) Representative: Siemens Healthineers Patent Attorneys

(57) **Abstract**

Techniques are disclosed for reconstructing Magnetic Resonance Imaging, MRI, images based on MRI data that asymmetrically samples K-space in accordance with a partial Fourier acquisition scheme. A processing pipeline (160) for such reconstruction is flexibly configured depending on one or more settings of the partial Fourier acquisition scheme. The processing pipeline can include a trained function, e.g., implemented as a neural network (161, 163), to solve one or more tasks such as deblurring, super-resolution, or denoising.

## Description

### TECHNICAL FIELD

Various examples of the disclosure generally pertain to processing magnetic resonance imaging data acquired using a partial Fourier acquisition scheme. According to various examples of the disclosure, a neural network is employed in a respective processing pipeline.

### BACKGROUND

Magnetic resonance imaging (MRI) is used widely in the clinical procedure. To speed-up MRI data acquisition, the k-space is usually not entirely sampled. Besides partially parallel acquisition (PPA) schemes using multiple receiver coils, partial Fourier (PF) acquisition schemes are employed to acquire less samples in the k-space and, therefore, reduce scan time. PF acquisition schemes also have benefits for diffusion-weighted imaging, to reduce the distance to the K-space center from one side and thereby enable shorter echo times.

With PF acquisition schemes, samples on one side of k-space are omitted. PF acquisition schemes asymmetrically sample the k-space. Asymmetrical PF sampling can in general be applied along all different encoding directions (PF directions). Furthermore, it can be applied along different PF directions simultaneously, e.g., PF acquisition both along the phase-encoding and the partition-encoding direction in case of a 3-D acquisition. Beyond such setting of the PF acquisition scheme that pertains to the used PF directions, PF acquisition schemes further support different ratios of sampled to un-sampled fractions in the k-space (PF factors). Typical PF factors are 5/8, 6/8, 7/8. For a PF factor of 5/8, the ratio of the sample k-space fraction to the unsampled k-space fraction is 5/3.

Various techniques of processing MRI data that asymmetrically samples the K-space using PF acquisition schemes to reconstruct an MRI image are known. A central idea of reconstructing an MRI image from MRI data that asymmetrically samples the K-space using a PF acquisition scheme is based on the observation that the phase of MRI images (for complex-valued MRI images) usually has a relatively slow spatial resolution and, hence, can be estimated from the incomplete MRI data.

According to prior art solutions, the missing k-space samples can be filled/reconstructed. The most simple and robust one is zero-padding, which - although clinically still widely used - results in image blurring. Other techniques such as Homodyne, Margosian or POCS partially recover sharpness. Assumptions on the smoothness of the background phase are made. However, these techniques all assume that the phase information of the complex image is contained in the asymmetrically sampled, low-frequency part of k-space. If this assumption is violated, these methods lead to image artifacts. For example, well smoothness of the phase is valid in various MRI use cases. Some MRI use cases, in particular, in the context of diffusion-weighted imaging, exhibit rapid phase variations. This can be due to motion-prone anatomies such as the abdomen.

One approach for reconstructing an MRI image based on MRI data that asymmetrically samples the K-space using a PF acquisition scheme is a Deep Learning (DL)-based PF reconstruction.

See Gadjimuradov, Fasil, et al. "Robust partial Fourier reconstruction for diffusion-weighted imaging using a recurrent convolutional neural network." Magnetic Resonance in Medicine 87.4 (2022): 2018-2033. The idea of DL-based PF reconstruction is to train a neural network algorithm (as an example of a trained function; also simply neural network, NN) to fill in the missing k-space information.

Also see Almansour H, Herrmann J, Gassenmaier S, et al. Combined Deep Learning-based Super-Resolution and Partial Fourier Reconstruction for Gradient Echo Sequences in Abdominal MRI at 3 Tesla: Shortening Breath-Hold Time and Improving Image Sharpness and Lesion Conspicuity. Academic Radiology. 2022 Jul:S1076-6332(22)00327-0. DOI: 10.1016/j.acra.2022.06.003. PMID: 35810067.

Such approaches have been shown to outperform the previously mentioned traditional methods both with respect to recovery of sharpness as well as robustness to artifacts. However, one restriction with prior art implementations of DL-based PF reconstruction is that the NN to be trained for one specific PF factor, i.e., it does not generalize across different PF factors. E.g., applying a NN which has been trained for a PF factor of 6/8 on a dataset acquired with a PF factor of 5/8 or 7/8 shows artifacts and remaining blurring.

One prior art solution of the problem that NNs do not generalize across different PF factors is to train, integrate, and provide a separate NNs for each PF-factor. Assuming that four different PF factors can be selected for data acquisition (e.g., 5/8, 6/8, 7/8, off), PF along one single PF direction would require four separate NNs. In addition, when asymmetric sampling is performed in multiple PF directions, i.e., readout and phase encode directions, the number of possible configurations multiplies. A large number of NNs would need to be trained and deployed separately. For example, for PF acquisition along two PF directions with four settings each, this would already result in 4 * 4 = 16 separate NNs. Still further, the interpretation of PF factors can differ across various sequences. I.e., a nominal PF factor of 5/8 (= 0.625) can be realized with slightly different numerical factors (e.g. 0.6 and 0.65), depending on the sequence type (TSE/DWI/VIBE/...). This can prevent the applicability of trained NNs across different sequences. Besides this, there are use cases that choose the PF factor based on protocol settings and a continuous range of PF factors needs to be supported. This includes the SPACE sequence, where the PF factor in phase-encode direction is dictated by the echo train. This multitude of different required independent NNs makes developments or re-trainings more difficult, error-prone and time-consuming.

### SUMMARY

Accordingly, there is a need for advanced techniques of processing MRI data that has been acquired using a PF acquisition scheme. A need exists for advanced techniques that overcome or mitigate at least some of the above-identified drawbacks and restrictions. Specifically, a need exists for advanced techniques that can flexibly handle different settings of the PF acquisition scheme.

A computer-implemented method of processing MRI data is disclosed. The method includes obtaining MRI data. The MRI data asymmetrically samples the K-space. The asymmetrical sampling is in accordance with a partial Fourier acquisition scheme. The method also includes configuring a processing pipeline to reconstruct an MRI image. Said configuring is based on one or more settings of the partial Fourier acquisition scheme. Said reconstructing is based on the MRI data. The method also includes providing the MRI data to the processing pipeline. The method further includes obtaining, from the processing pipeline, the MRI image.

A program code is disclosed. The program code can be loaded and executed by at least one processor. The at least one processor, upon loading and executing the program code, performs a method of processing MRI data. The method includes obtaining MRI data. The MRI data asymmetrically samples the K-space. The asymmetrical sampling is in accordance with a partial Fourier acquisition scheme. The method also includes configuring a processing pipeline to reconstruct an MRI image. Said configuring is based on one or more settings of the partial Fourier acquisition scheme. Said reconstructing is based on the MRI data. The method also includes providing the MRI data to the processing pipeline. The method further includes obtaining, from the processing pipeline, the MRI image.

A computer program or a computer-readable storage medium as disclosed. The computer program or the computer readable storage medium includes program code. The program code can be loaded and executed by at least one processor. The at least one processor, upon loading and executing the program code, performs a method of processing MRI data. The method includes obtaining MRI data. The MRI data asymmetrically samples the K-space. The asymmetrical sampling is in accordance with a partial Fourier acquisition scheme. The method also includes configuring a processing pipeline to reconstruct an MRI image. Said configuring is based on one or more settings of the partial Fourier acquisition scheme. Said reconstructing is based on the MRI data. The method also includes providing the MRI data to the processing pipeline. The method further includes obtaining, from the processing pipeline, the MRI image.

A processing device that includes a processor and a memory is disclosed. The processor is configured to load program code from the memory. The processor is configured to execute the program code. The at least one processor, upon loading and executing the program code, performs a method of processing MRI data. The method includes obtaining MRI data. The MRI data asymmetrically samples the K-space. The asymmetrical sampling is in accordance with a partial Fourier acquisition scheme. The method also includes configuring a processing pipeline to reconstruct an MRI image. Said configuring is based on one or more settings of the partial Fourier acquisition scheme. Said reconstructing is based on the MRI data. The method also includes providing the MRI data to the processing pipeline. The method further includes obtaining, from the processing pipeline, the MRI image.

It is to be understood that the features mentioned above and those yet to be explained below may be used not only in the respective combinations indicated, but also in other combinations or in isolation without departing from the scope of the invention.

### BRIEF DESCRIPTION

FIG. 1 schematically illustrates sampling of the K-space for a PF acquisition scheme.
FIG. 2 schematically illustrates a processing device according to various examples.
FIG. 3 is a flowchart of a method according to various examples.
FIG. 4 is a flowchart of a method according to various examples.
FIG. 5 schematically illustrates a processing pipeline for reconstructing an MRI image based on MRI data that has been acquired using a PF acquisition scheme according to various examples.
FIG. 6 schematically illustrates a processing pipeline for reconstructing an MRI image based on MRI data that has been acquired using a PF acquisition scheme according to various examples.

### DETAILED DESCRIPTION

Some examples of the present disclosure generally provide for a plurality of circuits or other electrical devices. All references to the circuits and other electrical devices and the functionality provided by each are not intended to be limited to encompassing only what is illustrated and described herein. While particular labels may be assigned to the various circuits or other electrical devices disclosed, such labels are not intended to limit the scope of operation for the circuits and the other electrical devices. Such circuits and other electrical devices may be combined with each other and/or separated in any manner based on the particular type of electrical implementation that is desired. It is recognized that any circuit or other electrical device disclosed herein may include any number of microcontrollers, a graphics processor unit (GPU), integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, any one or more of the electrical devices may be configured to execute a program code that is embodied in a non-transitory computer readable medium programmed to perform any number of the functions as disclosed.

In the following, embodiments of the invention will be described in detail with reference to the accompanying drawings. It is to be understood that the following description of embodiments is not to be taken in a limiting sense. The scope of the invention is not intended to be limited by the embodiments described hereinafter or by the drawings, which are taken to be illustrative only.

The drawings are to be regarded as being schematic representations and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling. A coupling between components may also be established over a wireless connection. Functional blocks may be implemented in hardware, firmware, software, or a combination thereof.

Hereinafter, techniques of processing MRI data are disclosed. The MRI data is acquired using a PF acquisition scheme. The MRI data may be 2-D or 3-D MRI data. An MRI image is reconstructed. This includes reconstructing MRI data in a section of the k-space that has not been acquired due to the asymmetrical sampling.

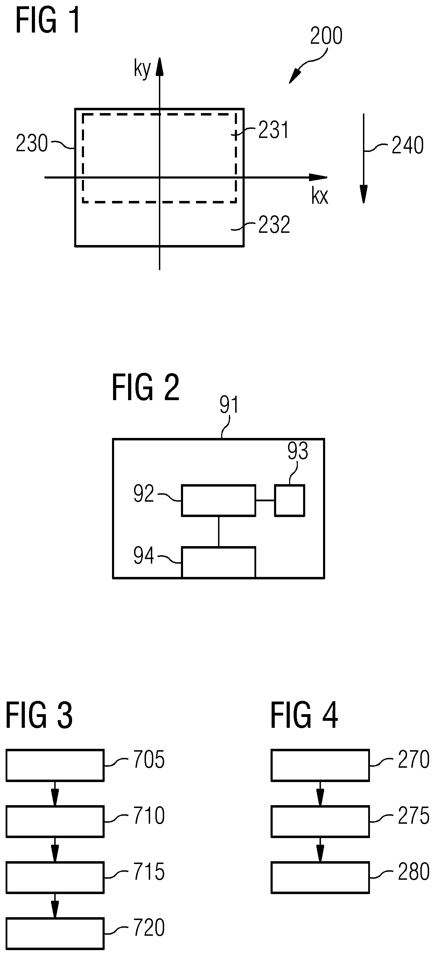

FIG. 1 shows the k-space 200. FIG. 1 illustrates a region 230 in which samples of MRI data are required to reconstruct an MRI image, considering Nyquist's theorem. The region 230 is composed of a first section 231 in which measurement samples are acquired using the PF acquisition scheme and a second section 232 in which measurement samples are not acquired, but later on reconstructed. As illustrated, the PF acquisition scheme asymmetrically samples the k-space 200 along the PF direction 240. The degree of asymmetry - i.e., the ratio of the sizes of the sections 231, 232 - defines the PF factor. Typical PF factors are 5/8, 6/8, or 7/8. The PF acquisition scheme also includes other settings beyond the PF factor. For instance, the particular PF direction - in the scenario of FIG. 1, it is the direction 240 - can vary. Also, the PF acquisition scheme can asymmetrically sample the k-space along multiple PF directions.

Hereinafter, computer-implemented techniques of reconstructing the MRI data in the section 232 are disclosed. These techniques can flexibly handle one more settings of the PF acquisition scheme, e.g., varying PF factors and/or varying PF directions. A respective processing device is shown in FIG. 2.

FIG. 2 schematically illustrates a processing device 91. The processing device 91 includes a processor 92 and a memory 93.

The processing device 91 also includes an interface 94. The processor 92 can load MRI data acquired by an MRI apparatus via the interface 94. For instance, the processor 92 can access a database in which the MRI data is stored. The processor 92 can load program code from the memory 93 and execute the program code. The processor 92, upon loading and executing the program code, can perform techniques as disclosed herein, e.g., providing MRI data to a processing pipeline and obtaining, from the processing pipeline, an MRI image; configuring the processing pipeline to reconstruct the MRI image based on MRI data received via the interface 94; configuring the processing pipeline based on one or more settings of the PF acquisition scheme; training a NN..

FIG. 3 is a flowchart of a method according to various examples. The method of FIG. 3 can be executed by a processor based on program code that is loaded from a memory. For instance, the method of FIG. 3 can be executed by the processor 92 of the processing device 91, upon loading and executing program code that is stored in the memory 93.

The method pertains to processing MRI data.

At box 705, MRI data is obtained. The MRI data asymmetrically samples the k-space. A partial PF acquisition scheme is used. An example of the k-space arrangement of samples of such MRI data that has been discussed in connection with FIG. 1. The MRI data can be obtained from an MRI apparatus or can be loaded from a database.

At box 710, a PPA reconstruction is optionally employed. For PPA acceleration, using an acceleration factor, only a certain fraction of samples are acquired in the k-space. K-space samples are alternatingly acquired and omitted along a respective trajectory. Reference techniques of such parallel imaging reconstruction are available, e.g., SENSE or GRAPPA. PPA reconstruction employs prior art techniques. The particular technique is not germane to the techniques disclosed herein.

At box 715, a processing pipeline to reconstruct an MRI image based on the MRI data is configured.

Such configuring of the processing pipeline pertains to preconditioning the processing pipeline, prior to executing the reconstruction. For instance, one or more hyperparameters of the processing pipeline can be set. For example, one or more parameters or weights of one or blocks or sections of the processing pipeline can be set. The reconstruction itself is not yet triggered in box 715. Accordingly, the processing pipeline is preconditioned in view of the particular one or more settings of the PF acquisition scheme. Thereby, variable settings of the PF acquisition scheme can be taken into account when reconstructing an MRI image. Accordingly, one or more settings of the PF acquisition scheme are provided as an additional input to the processing pipeline. The processing pipeline can therefore be used for a broad range of PF factors and/or PF directions, sequences, etc..

At box 720, the processing pipeline operates based on an input that is based on the MRI data (optionally, after PPA reconstruction in box 710). An MRI image is obtained.

According to various examples, the processing pipeline includes multiple sections. It is possible that the processing pipelines includes multiple iterations, each iteration comprising execution of one or more respective sections. According to various examples, at least one section of the processing pipeline is implemented by a trained function. An example of a trained function is a machine-learning algorithm such as a deep NN. According to examples, a variational or unrolled NN can implement the multiple iterations. Such a NN can be trained to solve various tasks. In particular, the NN can implement an image-2-image transformation in order to reduce artifacts or otherwise enhance a current estimate of the MRI image that is reconstructed by the processing pipeline. The particular task or tasks solved by the NN depend on its training. Details with respect to the training of the NN are explained in connection with FIG. 4.

FIG. 4 is a flowchart of a method according to various examples. The method of FIG. 4 can be executed by a processor based on program code that is loaded from a memory. For instance, the method of FIG. 4 can be executed by the processor 92 of the processing device 91, upon loading and executing program code that is stored in the memory 93.

The method pertains to training a NN of a processing pipeline for reconstructing an MRI image based on MRI data that asymmetrically samples the K-space using a PF acquisition scheme. Accordingly, the method of FIG. 4 can precede the method of FIG. 3.

At box 270, ground-truth MRI data is obtained. Typically, the ground-truth MRI data fully samples the K-space. I.e., PF acquisition is not employed (i.e., a PF factor of zero is used).

At box 275, the ground-truth MRI data is augmented. This is done to obtain training MRI data that, in the training itself, serves as an input to the NN for the training.

The particular implementation of the augmenting depends on the task to be solved by the NN. For example, different samples in the K-space can be discarded and then zero padded. This mimics a state-of-the-art reconstruction of an MRI image based on MRI data acquired using a PF acquisition scheme.

The augmentation can, in particular, depend on one or more settings of the PF acquisition scheme. Samples in the K-space can be discarded in accordance with multiple settings of the PF acquisition scheme. For example, different samples can be discarded depending on the PF direction. More or fewer MRI data samples are discarded and then zero padded in the K-space depending on the particular PF factor. Such approach is an example of a training of the NN to solve the task of deblurring, i.e., reducing blurring artifacts that are due to the asymmetrical sampling and zero padding.

However, this is only one example of a task for which the NN can be trained. Alternatively or additionally, the NN can be trained to solve further or other tasks. To give some examples, it would be possible that the NN is trained to solve a super-resolution task. Here, the resolution of the input MRI image is decreased if compared to the output MRI image. For this, the ground-truth MRI data can be augmented accordingly, e.g., in the k-space space by cropping the acquired samples and then the downsampled image is generated by a subsequent Fourier transform. In image space, there are different methods. For example, a downsampling factor of 2 could be achieved by taking pixel values from alternating rows and columns. Alternatively or additionally, the NN can be trained to solve a denoising task. This reduces noise in the MRI image. For instance, the training MRI data can be obtained by augmenting the ground-truth MRI data by adding noise. For instance, image noise can be added to the MRI image representation of the ground-truth MRI data.

Then, at box 280, the NN is trained by inputting each of the multiple training MRI data into the NN and minimizing a loss. Backpropagation is used. The loss is calculated with respect to the ground-truth MRI data. The loss can be defined in the image space or K-space. For instance, a difference between an MRI image is reconstructed by the NN in its current training state based on the respective input and an MRI image reconstructed based on the ground-truth MRI data can be considered. For instance, a difference between a K-space representation of the reconstructed MRI image obtained from the NN in its current training state and the ground-truth MRI data can be considered.

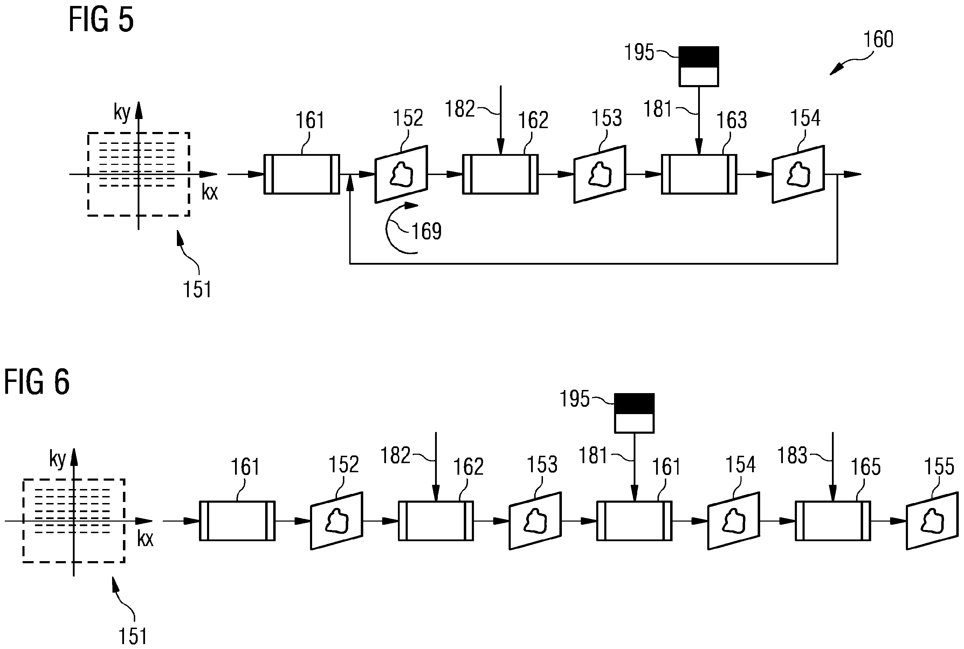

In a scenario in which multiple NNs are combined in a processing pipeline, such multiple NNs can be trained end-to-end in combined backpropagation runs (cf. FIG. 5 and FIG. 6, here the NN 162 for multiple iterations 169 and the NN 165).

FIG. 5 schematically illustrates an example processing pipeline 160. The processing pipeline obtains the MRI data 151 that asymmetrically samples the K-space using the PF acquisition scheme. An initial reconstruction is performed at block 161. Here, e.g., missing K-space samples in the section 232 can be filled with zeros (zero padding) or other dummy data. Then, a respective current estimate 152 of the MRI image is determined based on the output of block 161. This can include a Fourier transform from K-space to image space.

The current estimate 152 is not a perfect reconstruction of the MRI image. It includes artifacts. This is because the initial reconstruction performed at box 161 has certain deficiencies, e.g., in accordance with the limitations associated with zero padding.

Accordingly, the current estimate 152 is further processed downstream along the processing pipeline 160. The current estimate 152 MRI image is provided as an input to a train function, typically implemented by a NN 162.

The NN 162 can be a convolutional NN. A generative NN can be used that is operating based on randomized data. The NN can include one or more convolutional layers. The NN 162 operates in image space. The NN 162 provides an image-to-image processing. Various tasks can be solved by the NN 162, depending on its training. Details have been discussed in connection with FIG. 4. The NN 162 can solve one or more of the following tasks: deblurring; denoising; super-resolution.

The output of the NN 162 is an MRI image 153 that can be processed in a filter block 163 that is arranged downstream of the NN 162. The filter block 163 is configured to enforce data consistency between the output of the NN 162, i.e., data consistency between the MRI image 153, and the measured MRI data.

For example, the filter block 163 is configured to prioritize measurement samples in K-space that are included in the MRI data that has been initially acquired, i.e., measured K-space samples. This can be referred to as PF sampling.

There are different options for implementing the filter block 163. For instance, a manually parameterized filter function can be employed that filters in K-space. In some examples, a trained function, e.g., a NN can be employed.

The MRI image 153 can be transformed by a Fourier transform operation in the K-space and then the respective filtering operation can be applied. The filter block, accordingly, operates as a data-consistency operation that prioritizes the actually measured K-space samples. Hard filtering or soft filtering can be applied to achieve such prioritization. For instance, hard filtering can replace all K-space samples of the K-space representation of the image 153 with the measured K-space samples. Soft filtering can apply a combination of the K-space samples of the K-space representation of the image 153 in the section 231 and the measured K-space samples in that section 321.

The filter block 163 outputs an MRI image 154 (optionally, after an inverse Fourier transform from the k-space 200 to the image space). In some examples, the image 154 is the final result of the reconstruction. Optionally, the processing pipeline 160 includes multiple iterations 169 of the NN 162 and the filter block 163. An input of the train functioned function / NN 162 in a subsequent one of the iterations 169 is based on an output of the filter block 163 and the preceding one of the multiple iterations 169. I.e., the current estimate 152 can be updated from iteration 169 to iteration 169 based on the output of the filter block 163 (in the image space, after respective Fourier transform of the filter operation operating in the K-space).

Such iterations 169 can implement the NN 162 as unrolled NN 162. Here, different parameters - e.g., weights and/or biases - are used for different iterations 169 in the NN 162. It is not necessary in all scenarios that the processing pipeline 160 includes multiple iterations 169. For instance, instead of implementing multiple iterations 169, a further NN may be implemented downstream of the filter block 163 as illustrated in FIG. 5 for the NN 165. Then, the NN 165 outputs the MRI image 155 which is the final result of the reconstruction.

As a general rule, the NN 165 can be configured in the same manner as the NN 162. For example, the NN 165 can be a convolutional NN. A generator of NN can be employed. Aspects disclosed hereinafter in connection with the NN 162 are alternatively or additionally applicable to the NN 165.

Next, techniques will be described how to configure the processing pipeline 160 depending on one or more settings of the PF acquisition scheme used to acquire the MRI data 151. This applies to, both, FIG. 5 and FIG. 6 as well as variations thereof.

According to examples, a representation of the section 231 and/or the section 232 is provided to the filter block 163. In other words, a mask image 195 can be provided that defines the sampling range of the PF acquisition scheme. Such mask image 195 is defined in the k-space 200. Such mask image 195 can encode the sections 231, 232 (cf. FIG. 1), e.g., include black pixel values for K-space positions within the section 231 and include white pixel values for K-space positions within the section 232. The mask image 195 does not encode the K-space trajectory used to acquire the K-space data. It does not reflect properties of the PPA scheme, if even used. I.e., the range of acquired K-space frequencies can be provided to the filter block 163. A respective input 181 is illustrated in FIG. 5 and FIG. 6. The mask image 195 can have the same dimensions as the k-space representation of the output MRI image 153 provided by the NN 162.

For illustration, for a manually parametrized filtering operation, such mask image 195 can be used in order to determine in which section of the K-space representation of the image 153 the prioritization of the measured samples is to be applied. For a NN implementing the filter block 163, various options are available to take into consideration such representation of the section 231 and/or the section 232. For instance, multiple network weights can be available for different representations of the section 231 and/or the section 232 and based on such input 181 the particular network weights can be selected.

As a general rule, the input 181 can be complex-valued or real-valued. For a complex-valued input 181, multiple channels of the respective image can be used to represent the real part and the imaginary part.

According to various examples, a set of parameters for at least a section of the processing pipeline 160 is determined depending on one or more settings of the PF acquisition scheme. For example, parameters (e.g., weights and/or biases) can be determined for the NN 162.

For example, each of a predefined sets of parameters can be associated with a respective predefined PF factor. The NN 162 is trained for a range of asymmetries. This provides the predefined sets of the parameters.

If the actual PF factor corresponds to one of the predefined factors, the respective set of predefined parameters is selected for executing the processing pipeline 160. On the other hand, if the actual PF factor of the PF acquisition scheme deviates from the PF parameters associated with the predefined sets of parameters: Then, it is possible to interpolate between respective parameters based on the actual PF factor used in the PF acquisition scheme. This may be linear interpolation and for each considered PF direction there may be only two fixed values. With the introduction of the tuple *λ* = (*λ*₁,...,*λ_{N}*) whose entries specify the amount of asymmetry for the respective PF direction, these PF factors are then also inputs of the NN 162 (cf. input 182 in FIG. 5; a respective input 183 is also illustrated for the NN 165 in the scenario FIG. 6). This, in other words, is an additional dependency of the NN 162.

In the scenario above, the particular parameters of at least a section of the processing pipeline 160 - e.g., of the NN 162 - are determined based on one or more settings of the PF acquisition scheme, e.g., the PF factor or the PF direction. In some examples, the processing pipeline 160 may include multiple parallel processing branches, each associated with respective parameters. Each of the multiple parallel branches can be associated with a respective setting of the PF acquisition scheme, e.g., with a respective PF factor or a respective PF direction. Each of these parallel branches can be trained individually in respective backpropagation processes (cf. FIG. 4, box 280). Then, based on the actual setting of the PF acquisition scheme used for acquiring the MRI data, outputs of the multiple parallel branches of the processing pipeline 160 can be combined. For instance, a weighted combination would be possible, to enable arbitrary selection of the PF factor. In other words, there may be separate branch-es/NNs for fixed PF factors and the output of such branches can be interpolated. For instance, multiple parallel branches can implement the NN 162 and the image 153 can be obtained from such weighted combination.

In some examples, the design of the NN 162 enables to take into account the one or more settings of the PF acquisition scheme. For example, the NN 162 can be a generative NN, e.g., a diffusion model. The generative NN includes a first input that is based on randomized data and further includes a second input. The second input is based on the one or more settings. A third input is based on the current estimate 152 of the MRI image. The generative NN generates images from a noise distribution but can be guided by additional prior knowledge. This prior knowledge corresponds to the one or more settings of the PF acquisition scheme, e.g., the PF factor or the range of acquired frequencies in the k-space. The conditioning may be soft, in the sense that a deviation from the measured frequencies is determined and it is incentivized to reduce the deviation. Or it may be hard/strict by enforcing the values to be identical in this frequency range. Diffusion models have the advantage that they can generate high quality images and that the dependency on the conditioning is rather flexible.

Other examples of designs of the NN 162 enabling to take into account the one or more settings of the PF acquisition are available. For example, the NN 162 may determine a latent representation of the current estimate 152 of the MRI image in a coordinate space. The coordinate space includes a respective dimension for each PF direction. A coordinate decoder can then be coupled downstream of the NN 162 and determine the output MR image 153. Thus, the NN maps on a latent space that is interpreted as a coordinate space. The amount of asymmetry for each PF direction can be considered as an additional dimension in this coordinate space. Such implementation is, in particular, helpful for NNs that also solve the task of super-resolution, as previously explained. In particular, using a coordinate space enables to implement various super-resolution factors. Scale-agnostic super-resolution tasks can be solved.

Coordinate NNs are described, inter alia, in Van Veen, Dave, et al. "Scale-Agnostic Super-Resolution in MRI using Feature-Based Coordinate Networks." arXiv preprint arXiv:2210.08676 (2022).

Summarizing, techniques have been disclosed which provide information regarding one or more settings of the PF acquisition scheme to a processing pipeline that reconstructs an MRI image based on MRI data that has been acquired using the PF acquisition scheme. The processing pipeline can include one or more NNs, i.e., DL reconstruction of PF accelerated MRI data is disclosed.

Various options have been disclosed how a configuration of the processing pipeline based on such one or more settings of the PF acquisition scheme can be employed. For example, an interpolation of distinct parameter values of the NN of the processing pipeline can be used to enable arbitrary PF factors. Also, the outputs of multiple parallel processing branches associated with different PF factors or combinations of PF factors and PF directions can be combined. An additional input image/mask image can be provided that encodes the range of the acquired K-space frequencies. A generative NN can be used. Hard or soft data consistency can be enforced. In one scenario, latent features of the NN are interpreted/defined in a coordinate space wherein the dimensions of the coordinate space are the PF directions. This also enables to select arbitrary PF factors.

Different PF directions can be supported, i.e., 2-D data or 3-D MRI data can be supported including readout direction. Here, partial for a reconstruction can be applied only for a subset of the considered dimension, e.g., only along the readout direction.

Such processing pipelines for reconstructing MRI data have the advantage of supporting arbitrary settings of the PF acquisition scheme. A wide range of PF factors can be supported. Various use cases can be supported. Various sequences for acquisition of the MRI data can be supported.

Although the invention has been shown and described with respect to certain preferred embodiments, equivalents and modifications will occur to others skilled in the art upon the reading and understanding of the specification. The present invention includes all such equivalents and modifications and is limited only by the scope of the appended claims.

For instance, while above an implementation of a train function by a NN has been disclosed, other implementations of machine-learning algorithms are conceivable. For instance, a support vector machine can be used.

Independent of the grammatical term usage, individuals with male, female or other gender identities are included within the term.

## Claims

1. A computer-implemented method of processing magnetic resonance imaging, MRI, data, the method comprising:
- obtaining (705) MRI data (151) that asymmetrically samples the k-space (200) in accordance with a partial Fourier acquisition scheme,
- based on one or more settings of the partial Fourier acquisition scheme, configuring (715) a processing pipeline (160) to reconstruct an MRI image (154, 155) based on the MRI data (151), and
- providing the MRI data (151) to the processing pipeline (160) and obtaining, from the processing pipeline (160), the MRI image (154, 155).

2. The computer-implemented method of claim 1,
wherein the processing pipeline (160) comprises a trained function (162) trained to solve, in a current estimate (152) of the MRI image, a de-blurring task to reduce blurring artifacts,
wherein the processing pipeline (160) further comprises a filter block (163) arranged downstream of the trained function (162) configured to enforce data consistency between an output of the trained function (162) and the MRI data.

3. The computer-implemented method of claim 2,
wherein the processing pipeline (160) comprises multiple iterations (169) of the trained function (162) and the filter block (163),
wherein an input of the trained function (162) in a subsequent one of the multiple iterations (169) is based on an output of the filter block (163) in a preceding one of the multiple iterations (169).

4. The computer-implemented method of claim 2 or 3, wherein the filter block (163) prioritizes, by hard filtering or soft filtering, a measured samples included in the MRI data (151) over reconstructed samples included in the output of the trained function (162).

5. The computer-implemented method of any one of claims 2 to 4,
wherein the trained function comprises a generative neural network comprising a first input that is based on randomized data and further comprising a second input that is based on the one or more settings and further comprising a third input that is based on the current estimate (152) of the MRI image.

6. The computer-implemented method of any one of claims 2 to 5,
wherein the trained function (162) determines a latent representation of the current estimate (152) of the MRI image in a coordinate space, the coordinate space comprising a respective dimension for each of at least one k-space direction (240) associated with the partial Fourier acquisition scheme,
wherein the processing pipeline (160) comprises a coordinate decoder coupled in-between the trained function (162) and the filter block (163) and used to determine an output based on the one or more settings.

7. The computer-implemented method of any one of claims 2 to 6,
wherein said configuring of the processing pipeline (160) comprises providing, to the filter block, a representation (195) of at least one of a first section (231) of the k-space (200) or a second section (232) of the k-space (200), the first section (231) being sampled and the second section (232) not being sampled by the partial Fourier acquisition scheme.

8. The computer-implemented method of any one of claims 2 to 7,
wherein the trained function is further trained to solve, in the current estimate of the MRI image, a super-resolution task to increase a resolution of the MRI image.

9. The computer-implemented method of any one of claims 2 to 8,
wherein the trained function is further trained to solve, in the current estimate of the MRI image, a denoising task to reduce noise in the MRI image.

10. A computer-implemented method of training the trained function of any one of claims 2 to 9, the method comprising:
- obtaining (270) ground-truth MRI data that fully samples the k-space,
- augmenting the ground-truth MRI data by discarding samples in the k-space in accordance with multiple settings of the partial Fourier acquisition scheme, to thereby obtain multiple training MRI data for the multiple settings, and
- training the trained function by inputting each of the multiple training MRI data and minimizing a loss determined based on an output of the trained function for each of the multiple training MRI data and with respect to the ground-truth MRI data.

11. The computer-implemented method of any one of the preceding claims,
wherein said configuring (715) of the processing pipeline comprises at least one of selecting between multiple predefined sets of parameters for at least a section (162, 163, 165) of the processing pipeline (160), or determining a set of parameters of at least a section (162, 163, 165) of the processing pipeline (160) by interpolating in-between predefined sets of parameters.

12. The computer-implemented method of claim 11,
wherein each of the predefined sets of parameters is associated with a respective predefined partial Fourier factor,
wherein said interpolating is based on a relation of the partial Fourier factor of the partial Fourier acquisition scheme with respect to the predefined partial Fourier factors.

13. The computer-implemented method of any one of the preceding claims,
wherein said configuring (715) of the processing pipeline (160) comprises determining combination parameters for a combination of outputs of multiple parallel branches of the processing pipeline (160).

14. The computer-implemented method of any one of the preceding claims,
wherein the one or more settings comprise at least one of a partial Fourier factor of the partial Fourier acquisition scheme, or at least one direction associated with the partial Fourier acquisition scheme.

15. A computer-readable storage medium comprising program code, the program code, upon being executed by a processor, causing the processor to perform the computer-implemented method of any one of the preceding claims.
